# EUROPEAN PATENT SPECIFICATION

(11) **EP 1 526 587 B1**
(45) Date of publication and mention of the grant of the patent: **28.03.2007**
(21) Application number: 04024551.6
(22) Date of filing: 14.10.2004
(51) Int. Cl.: H01L 41/04, H01L 41/187

(54) **Method for driving laminated piezoelectric device**
Verfahren zur Ansteuerung einer geschichteten piezoelektrischen Vorrichtung
Procédé de commande d'un dispositif piézoélectrique laminé

(30) Priority: 21.10.2003 JP 2003361125
(43) Date of publication of application: 27.04.2005
(73) Proprietor: DENSO CORPORATION, Kariya-city, Aichi-pref. 448-8661 (JP)
(72) Inventor: Nagase, Noboru, Kariya-city Aichi-pref., 448-8661 (JP); Naruse, Hideo, Kariya-city Aichi-pref., 448-8661 (JP); Fujii, Akira, Kariya-city Aichi-pref., 448-8661 (JP)
(74) Representative: TBK-Patent

(56) References cited:
- EP-A- 1 457 471
- DE-A1- 10 151 421
- US-A- 4 749 897
- US-A1- 2002 185 935

## Description

The present invention relates to a method for driving a laminated piezoelectric device including a piezoelectric layer and an inner electrode layer.

A laminated piezoelectric device having a plurality of piezoelectric layers and inner electrode layers laminated alternately is well known. By using a linear motion of the laminated piezoelectric device in a case where the device extends in accordance with voltage application, the device is used as a driving power source of an actuator for switching an open-close valve of an injector in a fuel injection system of an internal combustion engine.

Here, capacitance of the piezoelectric layer changes largely in accordance with temperature change. For example, when the temperature changes in a range between -20°C and 160°C, the capacitance may change about a few times larger.

Therefore, a voltage between both sides of the laminated piezoelectric device in a laminating direction and electric energy supplied to the device when the laminated piezoelectric device is operated change largely in accordance with capacitance change.

Accordingly, it is required that the temperature dependence of capacitance in the laminated piezoelectric device is compensated with using certain control means.

A piezoelectric device according to a prior art is disclosed in Japanese Patent Application Publication No. 2002-101673. In the device, by using a complicated control circuit composed of a switching device, a diode, an inductor and the like, the temperature dependence of capacitance is compensated so that the laminated piezoelectric device extends uniformly without temperature dependence.

However, a method with using the complicated control circuit disclosed in the prior art has following problems.
(1) A computation load becomes larger. Specifically, the method is not suitable for an in-vehicle system. This is because a microcomputer having high processing capacitance at a high cost is necessitated. Further, an additional microcomputer for controlling the laminated piezoelectric device is necessitated. Therefore, a manufacturing cost becomes higher.
(2) In case of the in-vehicle system, when the control circuit of the laminated piezoelectric device is integrated in an ECU (i.e., an electric control unit), electric power consumption becomes larger; and therefore, it is not desirable for the ECU.
(3) Specifically, when a noise in the control circuit becomes larger, a malfunction may occur so that it is difficult to control the laminated piezoelectric device appropriately.
(4) Further, when the control circuit is integrated in the ECU, the laminated piezoelectric device is often controlled on the basis of an operation signal including the large noise. Therefore, it is difficult to improve control accuracy.

Thus, a new method for driving the laminated piezoelectric device and for compensating the temperature dependence of capacitance without using the complicated control circuit is required. Further, it is required that the new method provides electric power saving feature and energy saving feature.

Document US 2002/0185935 A discloses a piezoelectric actuator and a method for driving the same. There is provided a piezoelectric actuator exhibiting a small change of displacement even when ranges of use conditions such as a temperature, an electric field and a compressive stress are broad, and a driving method of the piezoelectric actuator. In the piezoelectric actuator using a piezoelectric body undergoing displacement upon application of a voltage, a crystalline structure of the piezoelectric body substantially exists on a tetragonal system side outside of a morphotropic phase boundary (MPB) between the tetragonal system and a rhombohedral system under conditions of the lowest temperature, the lowest electric field and the maximum compressive stress that are used.

Document US 4,749,897 A discloses a driving device for a piezoelectric element for electrically driving a piezoelectric element to obtain a predetermined mechanical displacement, the piezoelectric element driving device being provided with a transformer having a primary winding and a secondary winding, the secondary winding being connected to the piezoelectric element; a switching element connected to the primary winding and controlling the amount of energy stored in an air-gap of the core of the transformer; and an energy control means for driving the switching element so that the amount of energy stored in the air-gap of the core of the transformer becomes a set value, the displacement of the piezoelectric element being controlled by the amount of energy stored in the air-gap of the core of the transformer.

In view of the above-described problem, it is an object of the present invention to provide a method for driving a laminated piezoelectric device and for compensating temperature dependence of capacitance. Further, the method provides electric power saving feature and energy saving feature.

This object is achieved by a method as defined in claim 1. Advantageous further developments are as set out in the dependent claims.

The method as defined in the claims can be obtained by a simple construction, and can perform the constant energy control without using a microcomputer. Therefore, communication with the ECU can be simplified, and it becomes easy to have a separate control from the ECU. Thus, when a driving circuit is separated from the ECU, electric power consumption can become smaller according to the performance improvement. Thus, there is no possibility for an ECU to malfunction by a noise.

Accordingly, the driving method of the laminated piezoelectric device can compensate the temperature dependence of capacitance without using the complicated control circuit, and the method provides electric power saving feature and energy saving feature.

The above and other objects, features and advantages of the present invention will become more apparent from the following detailed description made with reference to the accompanying drawings. In the drawings:
Fig. 1 is a perspective view showing a laminated piezoelectric device;
Fig. 2 is a diagram explaining a driving circuit of the laminated piezoelectric device;
Fig. 3 is a graph showing a relationship between a rate of temperature dependence of piezoelectric modulus D33 and temperature, according to the present invention;
Fig. 4 is a graph showing a relationship between a rate of temperature dependence of capacitance and temperature, according to the present invention;
Fig. 5 is a graph showing relationships among the rate of temperature dependence of the piezoelectric modulus D33, a square root of the rate of temperature dependence of the capacitance, and temperature, according to the present invention;
Fig. 6 is a graph showing a relationship between a rate of temperature dependence of extension and temperature in case of controlling energy to be constant and in case of controlling voltage to be constant, according to the present invention; and
Fig. 7 is a schematic view showing an injector according to the present invention.

The present invention relates to a method for driving a laminated piezoelectric device, used as a driving power source of an injector for injecting fuel in an internal combustion engine, which comprises a piezoelectric stack and a pair of side electrodes. The piezoelectric stack includes a plurality of piezoelectric layers and inner electrode layers, which are laminated alternately, and each side electrode is disposed on a side of the piezoelectric stack for energizing every two inner electrode layers. Each piezoelectric layer has a rate of temperature dependence of piezoelectric modulus D33 defined as RA, a rate of temperature dependence of capacitance defined as RC, and a constant value defined as K. The piezoelectric layer is made of piezoelectric material having a relationship expressed as RA=K (RC)^{½}. The method is characterized in that the inner electric layers are energized to keep energy of the laminated piezoelectric device constant.

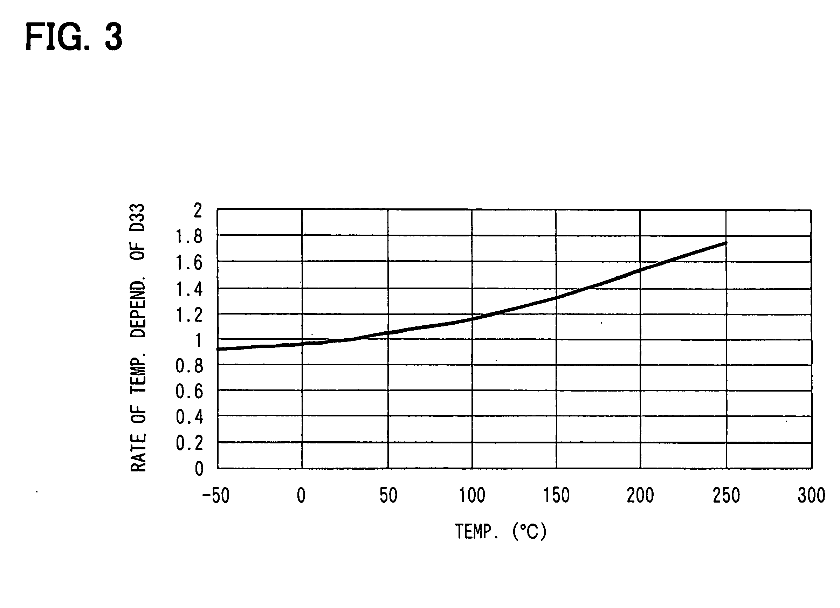

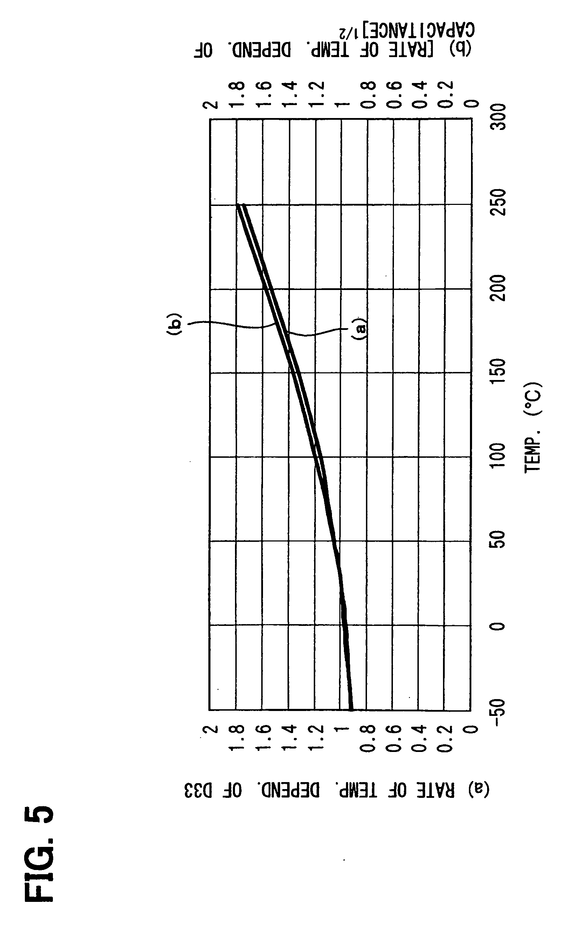

In the present invention, the piezoelectric layer is made of piezoelectric material, in which the rate of temperature dependence of the piezoelectric modulus D33 is described as K (RC)^{½}. In this case, a curve of the temperature dependence of the piezoelectric modulus D33 (shown in later described Fig. 3) and a curve of a value of (RATE OF TEMPERATURE DEPENDENCE OF CAPACITANCE)^{½} become almost parallel each other (See later described Fig. 5). One of the curves is shifted up and down by a constant value of K from the other one of the curves.

When the piezoelectric layers made of the above material are energized, electric energy per one piezoelectric layer is shown as (CAPACITANCE)X(VOLTAGE APPLIED TO BOTH SIDES OF PIEZOELECTRIC LAYERS)²÷2.

By controlling the above value to be constant, extension of the piezoelectric layer becomes almost constant without temperature dependence.

Here, the extension of the piezoelectric layer is in proportion to a value obtained by multiplying D33 by the applied voltage applied to the piezoelectric layer. When the voltage to be applied to the piezoelectric layers is defined as U, the electric energy is described as (ELECTRIC ENERGY)=(CAPACITANCE)XU² ÷ 2. Accordingly, the extension of the piezoelectric layer is described as D33X(2X(ELECTRIC ENERGY) ÷ (CAPACITANCE)^{½}.

Thus, the extension of the piezoelectric layer is in proportion to D33 ÷ (CAPACITANCE)^{½} , when the electric energy is constant.

Accordingly, the extension of the piezoelectric layer becomes uniformly, when the piezoelectric layer is made of a material having a relationship expressed as RA=K(RC)^{½} in a case where the rate of temperature dependence of the piezoelectric modulus D33 is defined as RA, the rate of temperature dependence of capacitance is defined as RC, and a constant value is defined as K, and further, the piezoelectric layers are energized to keep energy constant. Thus, the laminated piezoelectric device having low temperature dependence of a displacement can be obtained.

In the above constant energy operation, since the energy depends on both of the capacitance and the applied voltage, eventually, the object of the invention can be obtained by controlling the voltage.

Therefore, the voltage control can be provided by an extremely simple circuit construction, compared with the control circuit or a driving circuit for compensating temperature dependence of a displacement of the laminated piezoelectric device disclosed in the prior art. Further, the driving circuit for performing a driving method according to the present invention can be provided without using an expensive microcomputer or a microcomputer consuming large electric power.

Thus, the present invention provides a method of driving a laminated piezoelectric device for compensating temperature dependence of capacitance without using the complicated control circuit, the method providing electric power saving feature and energy saving feature.

Specifically, the laminated piezoelectric device having a whole surface electrode construction, in which a side of the inner electrode layer exposes outside at an entire circumference of a side of the piezoelectric stack, can be used in the present invention. Further, another piezoelectric device having a partial surface electrode construction, in which a side of the inner electrode layer exposes outside partially from a side of the piezoelectric stack, can be used in the present invention.

By energizing the inner electrode layers, different potentials are applied to both sides of the piezoelectric layers in a laminating direction so that multiple piezoelectric layers extend. In the laminated piezoelectric device, multiple piezoelectric layers are laminated. Therefore, an extension of each piezoelectric layer is summed up so that a total extension of the whole piezoelectric layers is obtained.

The piezoelectric material composing the piezoelectric layers is, for example, an oxide having an ABO₃ perovskite-type structure such as PZT (i.e., lead zirconate titanate) or BaTiO₃ (i.e., barium titanate). In general, the third component can be added to these piezoelectric materials for the purpose of improving a d-constant value, a critical temperature Tc, temperature characteristics and mechanical strength. In case of PZT, an additive such as Ni, Nb, Zn, Fe, and Cr is added to a B-site in the structure. In case of BaTiO₃, in general, an A-site of the structure is replaced to another additive such as Ca, Sr, and Pb.

Next, the rates of temperature dependence of the piezoelectric modulus D33 and the capacitance are described as follows.

The piezoelectric modulus D33 at a temperature T0 is defined as D0, and the piezoelectric modulus D33 at another temperature T1 (Here, T1 is higher than T0.) is defined as D1. The rate RA of temperature dependence of the piezoelectric modulus D33 at the temperature T1 is determined as RA=(D1-D0)/D0.

Similarly, the capacitance at the temperature T0 is defined as C0, and the capacitance at the other temperature T1 (Here, T1 is higher than T0.) is defined as C1. The rate RC of temperature dependence of the capacitance at the temperature T1 is determined as RC=(C1-C0)/C0.

Here, K is a constant value, which does not depend on temperature.

Next, the constant value of K is in a range between 0.7 and 1.3.

When the piezoelectric layers are made of piezoelectric material having a small constant value of K, the extension of the piezoelectric layers becomes smaller in a high temperature range. When the piezoelectric layers are made of piezoelectric material having a large constant value of K, the extension of the piezoelectric layers tends to become larger in the high temperature range.

When the constant value of K is smaller than 0.7, the displacement of the piezoelectric layers becomes smaller in the high temperature range. Therefore, the piezoelectric material is unavailable for the piezoelectric layers in the high temperature range. Thus, the usable temperature range of the laminated piezoelectric device may be limited.

When the constant value of K is larger than 1.3, the displacement of the piezoelectric layers becomes larger in the high temperature range. Therefore, a problem may occur in such a manner that the piezoelectric layers hit other members disposed around the piezoelectric layers.

Further, as described later, the piezoelectric device is used for a driving power source of an actuator, and when oil (specifically, fuel in the third embodiment) is disposed between the piezoelectric layers and a counterpart for transmitting the displacement of the piezoelectric layers, the piezoelectric layers are required to extend much larger in a case where the viscosity of the oil is reduced in the high temperature range. Unless the piezoelectric layers extend largely, the displacement of the piezoelectric layers cannot be transmitted to the counterpart. In this case, when the extension of the piezoelectric layers becomes smaller in the high temperature range, a failure of movement of the actuator may cause. Thus, the constant value of K is preferably in a range between 0.7 and 1.3.

Further, the laminated piezoelectric device is suitably used as a driving power source of an injector for injecting fuel in an internal combustion engine.

The laminated piezoelectric device used for the driving power source of the injector, forms an excellent injector, a fuel injection quantity of which becomes constant without temperature dependence.

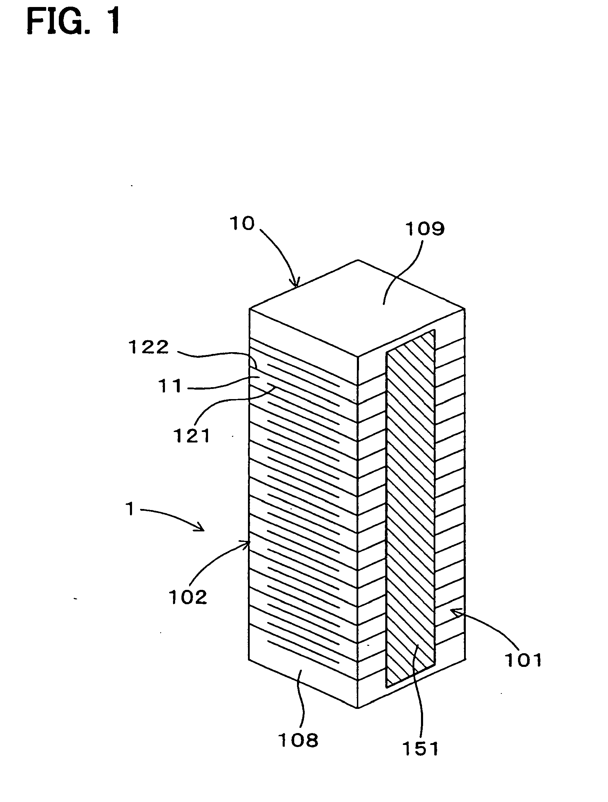

As shown in Fig. 1, the laminated piezoelectric device 1 includes a piezoelectric stack 10 and a pair of side electrodes 151. The piezoelectric stack 10 includes multiple piezoelectric layers 11 and inner electrode layers 121, 122, which are laminated alternately. Each side electrode 151 is disposed on a side 101, 102 of the piezoelectric stack 10 for energizing every two inner electrode layers 121, 122. Each piezoelectric layer 11 has a piezoelectric modulus defined as D33 with a rate of temperature dependence defined as RA, a rate of temperature dependence of capacitance defined as RC, and a constant value defined as K. The piezoelectric layer is made of piezoelectric material having a relationship expressed as RA=K(RC)^{½}. When the laminated piezoelectric device is operated, the inner electrode layers 11 are energized to keep energy of the laminated piezoelectric device 1 constant.

The laminated piezoelectric device 1 operated by the driving method according to the present invention is described as follows.

As shown in Fig. 1, the laminated piezoelectric device 1 has a partial electrode construction. Thus, each side electrode 151 is disposed on the side 101, 102 of the piezoelectric stack 10 composed of the piezoelectric layers 11 and the inner electrode layers 121, 122, which are laminated alternately (Here, only the side electrode 151 disposed on the side 101 is shown in Fig. 1. The other side electrode disposed on the other side 102 is not shown in Fig. 1, because the other side electrode is not visible in Fig. 1) . The side electrode 151 disposed on the side 101 and one end of the inner electrode layers 121 are electrically connected, and the other side electrode disposed on the other side 102 and the other end of the inner electrode layers 122 are electrically connected.

Each dummy layer 108, 109 is disposed on an end of the piezoelectric stack 10 in the laminating direction. Only one side of each dummy layer 108, 109 contacts the inner electrode layer 121, 122. The dummy layer 108, 109 does not extend when the device 1 is operated.

In the above laminated piezoelectric device 1, different electric potential is applied to each side electrode 151 so that the piezoelectric layers 11 are displaced. Thus, the laminated piezoelectric device 1 is operated.

The piezoelectric layers are made of PZT (i.e., lead zirconate titanate). The basic composition of PZT is Pb[(ZrₓTi₁₋ₓ)_{0.97}(Zn_{0.33}Nb_{0.67})_{0.03}]O₃+0.01Mn. Here, X is in a range between X=0.3 and X=0.7. A firing temperature is in a range between 1170°C and 1320°C (specifically, it is determined by every 30°C steps). Thus, the piezoelectric material of the piezoelectric layers is prepared.

The piezoelectric material has a rate of temperature dependence of a piezoelectric modulus D33 defined as RA, a rate of temperature dependence of capacitance defined as RC, and a constant value defined as K. The piezoelectric material has a relationship expressed as RA=K(RC)^{½}. Here, the constant value of K is in a range between 0.7 and 1.3 when the temperature is in a range between -50°C and 300°C a detailed measurement method is described later.

Further, each inner electrode layer 121, 122 is made of AgPd material. The side electrodes 151 are made of Ag material.

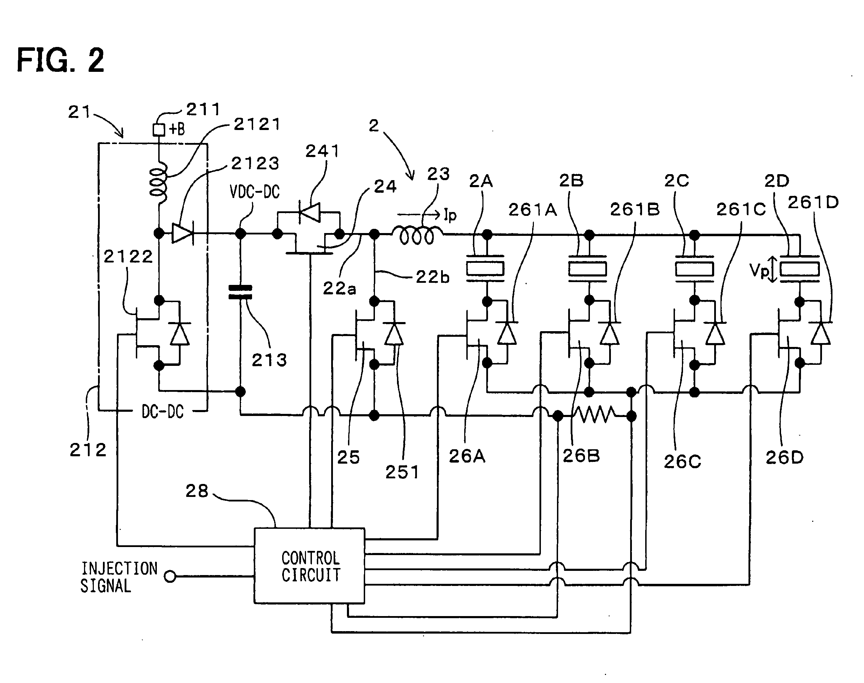

Next, a driving circuit 2 for performing the driving method according to the present invention is shown in Fig. 2.

The laminated piezoelectric device 1 extends linearly when the voltage is applied to the device 1. By using this linear motion of the device 1, the device 1 is used as a driving power source of an actuator for switching an open-close valve of an injector in a fuel injection system of an automotive vehicle's engine. The concrete construction of the injector and the like are described later.

The driving circuit 2 described in Fig. 2 has a construction for driving four laminated piezoelectric devices at the same time. This is, when the engine is a four-cylinder engine with four injectors, each laminated piezoelectric device 2A-2D is mounted on an injector 3 in each cylinder so that the device 2A-2D switches the injector 3 between injecting and stopping to inject fuel. The driving circuit 2 according to the present invention has the above construction so that the driving circuit 2 can operate four laminated piezoelectric devices at the same time.

The above driving circuit 2 includes a direct-current power source 21, which is composed of a battery 211, a DC-DC (i.e., direct-current-direct-current) converter 212 and a buffer capacitor 213. The battery 211 is mounted on the vehicle. The DC-DC converter 212 generates a direct-current voltage having several tens to several hundreds volts through the battery 211. The buffer capacitor 213 connects to an output terminal of the converter 212 in parallel. Thus, the driving circuit 2 outputs a voltage for charging the laminated piezoelectric devices 2A-2D.

The DC-DC converter 212 includes an inductor 2121 and a switching device 2122, which are connected to the battery 211 in series. When the switching device 2122 turns on, electric energy is accumulated in the inductor 2121. When the switching device 2122 turns off, the accumulated energy is charged up to a capacitor 213 from the inductor 2121 through a diode 2123. Here, the inductor 2121 generates reverse electromotive force in accordance with the accumulated energy. The buffer capacitor 213 has a comparatively large capacitance; and therefore, the capacitor 213 keeps the voltage almost constant even when the laminated piezoelectric devices 2A-2D are charged up.

The first energization path 22a is disposed between the buffer capacitor 213 of the direct-current power source 21 and the laminated piezoelectric devices 2A-2D for energizing the devices 2A-2D through the inductor 23. The energization path 22a connects to the first switching device 24 disposed in series between the buffer capacitor 213 and the inductor 23. The first switching device 24 is formed of a MOSFET having a parasitic diode (i.e., the first parasitic diode) 241. The first parasitic diode 241 connects to the buffer capacitor 213 to apply with reverse bias voltage between both terminals of the buffer capacitor 213.

The second energization path 22b is provided by the inductor 23 and the laminated piezoelectric devices 2A-2D. The second energization path 22b includes the second switching device 25 connecting to a mid point of connection between the inductor 23 and the first switching device 24. The inductor 23, the laminated piezoelectric devices 2A-2D, and the second switching device 25 form a closed circuit. The second switching device 25 is also formed of a MOSFET having a parasitic diode (i.e., the second parasitic diode) 251. The second parasitic diode 251 connects to the buffer capacitor 213 to apply with reverse bias voltage between both terminals of the buffer capacitor 213.

The first and second energization paths 22a, 22b are common to the laminated piezoelectric devices 2A-2D. The laminated piezoelectric devices 2A-2D as a driven object can be selected as follows. Each laminated piezoelectric device 2A-2D connects to a switching device (i.e., a selecting switching device when appropriate notation is necessitated) 26A-26D in series respectively. Thus, the selecting switching device 26A-26D corresponding to a piezoelectric stack 2A-2D of the injector in the injection system turns on.

The selecting switching device 26A-26D is formed of a MOSFET having a parasitic diode (i.e., a selecting parasitic diode) 261A-261D. The selecting parasitic diode 261A-261D connects to the buffer capacitor 213 to apply with reverse bias voltage between both terminals of the buffer capacitor 213.

A control signal is inputted from the control circuit 28 to each gate of the switching devices 24, 25, 26A-26D. As described above, only one of the selecting switching devices 26A-26D turns on so that one driven object among the laminated piezoelectric devices 2A-2D is selected. A pulse control signal is inputted to each gate of the switching devices 24, 25 so that the switching devices 24, 25 turn on or off, respectively. Thus, the laminated piezoelectric devices 2A-2D are controlled to charge and to discharge.

An injection signal from an ECU is inputted to the control circuit 28. The ECU described later controls the whole fuel injection system. The injection signal is a binary signal having a "L" signal and a "H" signal corresponding to an injection-state period. The control circuit 28 begins to charge the laminated piezoelectric device 2A-2D at a rising edge of the injection signal, and begins to discharge the laminated piezoelectric device 2A-2D at a decaying edge of the injection signal.

The charge control of the control circuit 28 is described as follows.

The control circuit 28 sets an on-state period and an off-state period of the first switching device 24 as follows so that the control signal of the first switching device 24 is outputted. Specifically, the on-state period keeps constant. When the energizing current becomes null, the off-state period is ended so that the first switching device 24 turns on, and then the next on-state period starts. The control signal continues to be outputted during a timer controlled predetermined time. Thus, the first switching device 24 turns on and off repeatedly several times corresponding to the timer controlled predetermined time.

The change of a charging current Ip over time is described as follows.

When the switching device 24 is in the on-state period, the charging current Ip flows in the first energization path 22a from the buffer capacitor 213 to the laminated piezoelectric device 2A-2D through the inductor 23. Here, the charging current Ip gradually increases. When the switching device 24 is in the off-state period, an inducted electromotive force generated in the inductor 23 applies with forward bias to the second parasitic diode 251. Thus, the charging current Ip flows in the second energization path 22b. Here, the charging current Ip gradually decreases by flywheel effect. Here, a resonant frequency of a circuit including the inductor 23 and the laminated piezoelectric devices 2A-2D is much higher than an on-off frequency of the first switching device 24, and therefore, the waveform of the on-off signal can be approximated to be a triangular waveform.

Here, in one cycle of the on-off signal, the charging current Ip has a maximum value (i.e. , a peak current) Ip_{PEAK}, which represents the current at the end point of the on-state period. The output voltage (i.e., the direct-current power source output voltage) of the direct current power source 21 is defined as V_{DC-DC}, which is the voltage between both terminals of the buffer capacitor 213, the laminated piezoelectric device voltage is defined as Vp, the time interval of the on-state period is defined as Ton, and the inductance of the inductor 23 is defined as L. The peak current Ip_{PEAK} is expressed as Ip_{PEAK}=(V_{DC-DC}-Vp)XTon/L. In this formula, the direct-current power source output voltage V_{DC-DC} can be approximated to be constant as described above.

The laminated piezoelectric device voltage Vp has an initial value of null at the beginning of charging the laminated piezoelectric device 2A-2D, and then, the voltage Vp gradually increases as time advances. Since the voltage Vp has the above time-profile, the voltage (i.e., V_{DC-DC}-Vp) applied to the inductor 23 during the on-state period of the switching device 24 gradually decreases as the charging of the laminated piezoelectric device 2A-2D advances.

Thus, since the induced electromotive force of the inductor 23 gradually decreases, the gradient of the charging current Ip in the on-state period also becomes smaller as the charging of the laminated piezoelectric device 2A-2D advances.

By setting the on-state period to be constant, the charging current becomes the triangular waveform and, the charging current totally shows the decreasing time-profile, which is opposite to the laminated piezoelectric device voltage Vp.

Here, the laminated piezoelectric device voltage Vp is inversely proportional to the capacitance C of the laminated piezoelectric device 2A-2D. Therefore, the increase of the capacitance C affects a direction to suppress the increasing rate of the laminated piezoelectric device voltage Vp.

The action directed to suppress the increasing rate of the laminated piezoelectric device voltage Vp affects a direction to relax the decreasing of the applied voltage applied to the inductor 23 in the on-state period of the switching device 24. Thus, as a whole, the action affects a direction to suppress the decreasing rate of the charging current Ip. This action affects a direction to increase the supplying rate of electric charges to supply to the laminated piezoelectric device 2A-2D, and therefore, the action affects a direction to increase the increasing rate of the laminated piezoelectric device voltage Vp. Thus, even when the capacitance of the laminated piezoelectric device 2A-2D increases, the time-profile of the laminated piezoelectric device voltage Vp does not change substantially.

On the other hand, since the laminated piezoelectric device voltage Vp does not change largely even when the capacitance of the laminated piezoelectric device 2A-2D increases, the time-profile of the charging current Ip also does not change substantially.

Further, the increase of the capacitance of the laminated piezoelectric device 2A-2D a little affects the laminated piezoelectric device voltage Vp and the charging current Ip. The weak affection to the voltage Vp and the current Ip has following characteristics.

Specifically, the energy supply by charging to the laminated piezoelectric device 2A-2D per unit time is expressed as a product of the laminated piezoelectric device voltage Vp and the charging current Ip. Here, the direction to suppress the increasing rate of the laminated piezoelectric device voltage Vp is the direction to decrease the energy supply per unit time. The direction to relax the decreasing of the charging current Ip is the direction to increase the energy supply per unit time. Thus, both directions are canceled each other. Accordingly, the energy supply per unit time can be much suppressed to depend on the variation of the capacitance of the laminated piezoelectric device 2A-2D.

Accordingly, only by controlling the charging time of the laminated piezoelectric device 2A-2D to be constant by the driving circuit 2, the energy supply to the laminated piezoelectric device 2A-2D can keep constant without using a feedback control method even when the capacitance of the laminated piezoelectric device 2A-2D is changed.

Thus, the driving circuit 2 shown in Fig. 2 controls the laminated piezoelectric device 1 by applying the voltage to keep energy constant.

Here, the capacitance C of the laminated piezoelectric device is measured in such a manner that a sample of the material composing the piezoelectric layer is preliminarily obtained, and then, the sample is connected to and measured by measuring equipment such as an impedance analyzer. The concrete measuring method is described below.

The constant energy control described above is to adjust the charging time to control the variation rate of the energy CV²/2 for supplying the laminated piezoelectric device in a range between -15% and +15% when the temperature is disposed in a range between -50°C and 300°C.

In the driving method with the above condition, the displacement of the laminated piezoelectric device 1 is in a range between -5% and +5% when the temperature is disposed in a range between -50°C and 300°C in a case where a thickness of the laminated piezoelectric device 1 before the voltage is applied to the device is used as a standard.

The driving circuit 2 according to the present invention is obviously described in Fig. 2. The circuit 2 has a simple construction, and can perform the constant energy control without using a microcomputer. Thus, the communication to the ECU is also simplified so that the circuit 2 for controlling can be separated from the ECU.

When the driving circuit 2 is separated from the ECU, the electric power consumption can become smaller according to the performance improvement. Thus, there is no possibility for the ECU to malfunction by a noise.

Accordingly, the above method provides the driving method of the laminated piezoelectric device for compensating the temperature dependence of capacitance without using the complicated control circuit, the method providing electric power saving feature and energy saving feature.

The laminated piezoelectric device shown in Fig. 1 has a partial electrode construction.

Further, a laminated piezoelectric device having a whole electrode construction and a unit type laminated piezoelectric device can be applied to the driving method of the present embodiment. The unit type laminated piezoelectric device is formed by laminating multiple piezoelectric units at a predetermined height, the unit having a piezoelectric layer and an inner electrode layer alternately laminated each other and being capable of working as a laminated piezoelectric device only by one unit.

A method for measuring a piezoelectric modulus D33 and an electric capacitance of a predetermined piezoelectric material is now described.

Specifically, a piezoelectric member (the composition of which is described above) is ground to be a predetermined thickness. Then, a pair of AgPd electrodes is printed on both sides of the member at 850°C. Then, the member is processed to be a disk shape having a diameter of 16mm. Thus, the obtained sample is dipped into silicone oil at 130°C. In the oil, the sample is applied with 2000V during 30 minutes so that a polarization process is performed. This is because a piezoelectric layer of the laminated piezoelectric device is also dipped into the silicone oil so that the polarization process is performed when the piezoelectric layer is formed.

After the polarization process is performed, both sides of the sample are connected to an impedance analyzer (which is a 4194A type analyzer manufactured by Hewlett-Packard Co.). Thus, a piezoelectric modulus D33 of the sample is measured by using a resonance-antiresonance method at a frequency of 100KHz to 200KHz, which is a frequency for generating a vibration in a radial direction. The capacitance of the sample is measured at 1KHz.

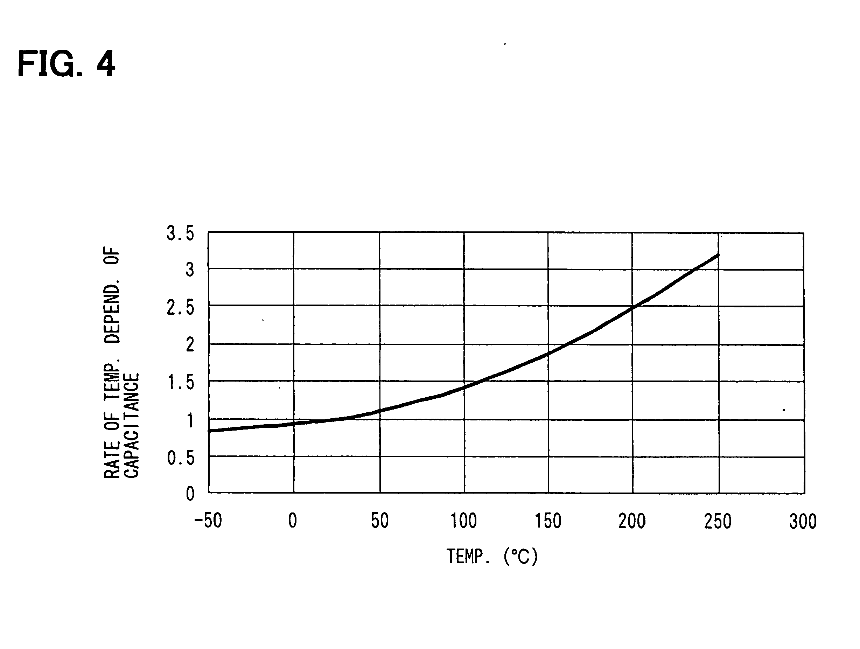

These measurement results are shown in Fig. 3 (showing a rate of temperature dependence of the piezoelectric modulus D33 in a temperature range between -50°C and 300°C) and Fig. 4 (showing a rate of temperature dependence of the capacitance in the temperature range between -50°C and 300°C).

Here, when the piezoelectric modulus D33 at the temperature of T0 is defined as D0 and the piezoelectric modulus D33 at the temperature of T1 (which is higher than T0) is defined as D1, the rate RA of temperature dependence of the piezoelectric modulus D33 at the temperature of T1 is determined as (RA1-RA0)/RA0. When the capacitance of the sample at the temperature of T0 is defined as C0 and the capacitance at the temperature of T1 (which is higher than T0) is defined as C1, the rate RC of temperature dependence of the capacitance at the temperature of T1 is determined as (C1-C0)/C0.

In view of Figs. 3 and 4, the rate of temperature dependence of the piezoelectric modulus D33 and the value of (RATE OF TEMPERATURE DEPEANDENCE OF CAPACITANCE)^{½} are shown in the graph of Fig. 5.

AS shown in Fig. 5, both curves almost coincide each other.

When the rate of temperature dependence of the piezoelectric modulus D33 is defined as RA and the rate of temperature dependence of the capacitance is defined as RC, both rates have the following relationship expressed as "RA=K(RC)^{½}, wherein K ≅1.0". Here, a variation of K is almost in a range between -1% and +1%.

Concerning to the above sample made of the piezoelectric material and having the disk shape, extension of the sample in case of controlling with constant energy and extension of the sample in case of controlling with constant voltage are compared.

Here, the constant energy control is such that the device is controlled to keep the value of NM²/2 constant when the voltage applied to both sides of the sample is defined as M and the capacitance of the sample at a certain temperature is defined as N. The variation of the value of NM²/2 can be permissible in a range between -10% and +10% with reference to a predetermined reference value.

The constant voltage control is such that a predetermined constant voltage is applied to the sample regardless of temperature. The variation of the voltage can be permissible in a range between -5% and +5% with reference to a predetermined reference voltage.

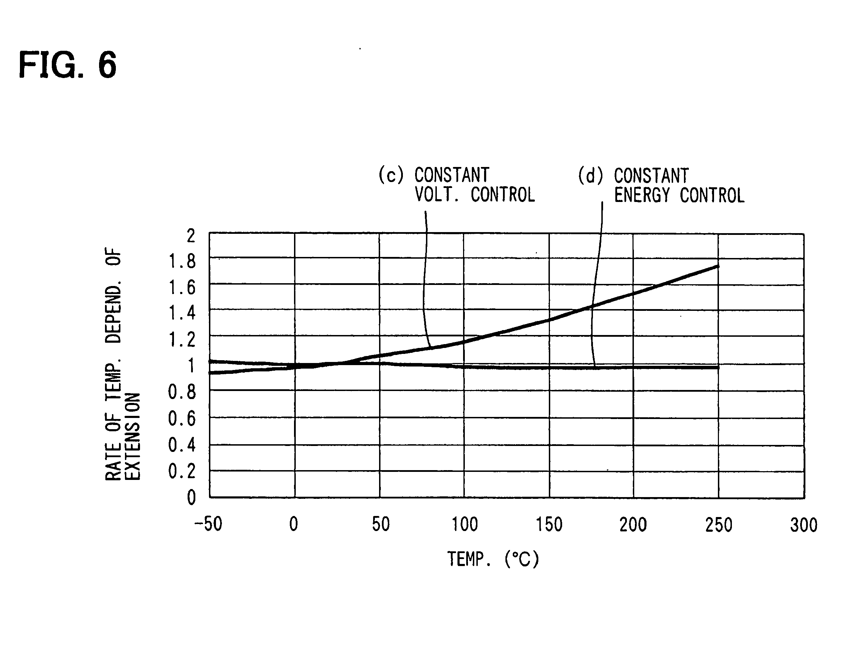

On the above condition, the rate of temperature dependence of the extension in each case of above two control methods is shown in the graph of Fig. 6. In Fig. 6, the vertical axis represents a rate of temperature dependence of the extension with reference to the extension at room temperature of 20°C. The horizontal axis represents temperature.

As shown in Fig. 6, in case of the constant energy control, the rate of extension of the sample does not depend on temperature substantially. However, in case of the constant voltage control, the rate of extension of the sample becomes larger as the temperature increases.

Thus, it is determined that the displacement of the sample does not depend on temperature when the sample is controlled to keep the energy constant, the sample being made of the piezoelectric material having the relationship of RA=K(RC)^{1/2} in a case where the rate of temperature dependence of the piezoelectric modulus D33 is defined as RA, the rate of temperature dependence of the capacitance is defined as RC, and the constant value is defined as K.

Accordingly, in the laminated piezoelectric device including the piezoelectric layer made of the above material, the displacement of the device does not depend on temperature.

An injector including the laminated piezoelectric device 1 having the driving method according to the present invention is described as follows.

A construction of the injector 3 is described as follows.

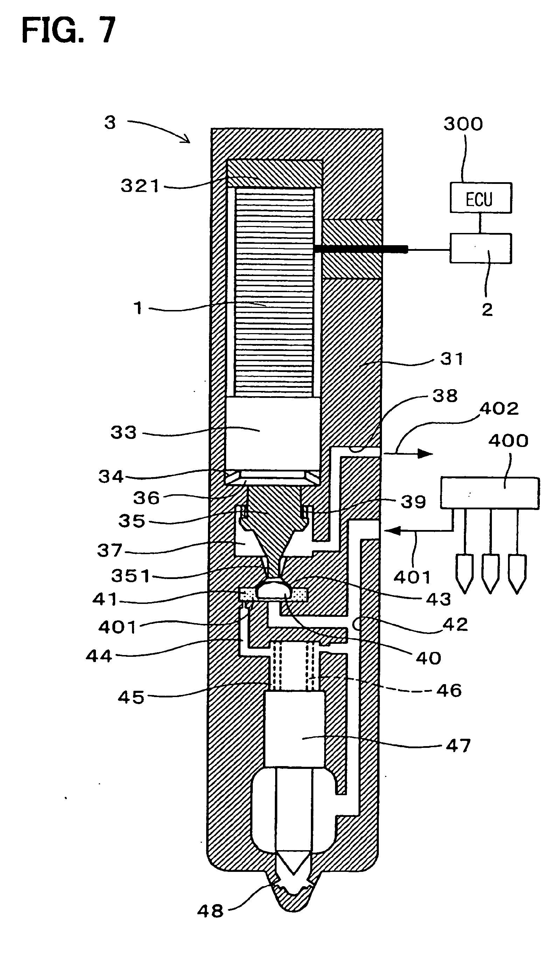

Fig. 7 is a cross-sectional view showing the injector 3 and parts disposed near the injector 3.

Fuel 401 having, for example, 150MPa high pressure is supplied to the injector 3 from a common rail 400. The injector 3 opens and closes in accordance with a control signal from ECU 300 and a driving circuit 2. When the injector 3 performs an opening operation, the injector 3 supplies and injects the fuel 401 to an engine, which is not shown in Fig. 7.

The ECU 300 includes a conventional microcomputer and the like. The ECU 300 loads engine-driving information such as an engine revolution, an opening degree of an accelerator and an engine coolant temperature, and the ECU 300 optimally controls a timing of fuel injection and an amount of fuel injection.

The injector 3 includes an injector body 31, which accommodates the laminated piezoelectric device 1 and a large diameter piston 33. The large diameter piston 33 slides in the injector body 31. Both of them are pressed each other with a belleville spring 34 so that both surfaces of them are attached each other. The laminated piezoelectric device 1 extends and shrinks in accordance with the control signal (i.e., a driving voltage) inputted into the ECU 300 and the driving circuit 2. When the laminated piezoelectric device 1 extends in accordance with the control signal, the large diameter piston 33 moves downside in Fig. 7 against the spring force of the belleville spring 34. A reference number 321 represents a piezoelectric stack holder plate.

A small diameter piston 35 is disposed under the large diameter piston 33. The small diameter piston 35 has a diameter smaller than the large diameter piston 33. A displacement-enhancing chamber 36 is formed between the large diameter piston 33 and the small diameter piston 35. The displacement-enhancing chamber 36 transmits a down force of the large diameter piston 33 to the small diameter piston 35 with fuel pressure in the displacement-enhancing chamber 36 when the large diameter piston 33 moves downward in Fig. 7. In this case, the displacement of the small diameter piston 35 is enhanced in accordance with a ratio of cross section between the large diameter piston 33 and the small diameter piston 35.

Thus, the displacement-enhancing chamber 36 enhances a small displacement of the laminated piezoelectric device 1, and then, the chamber 36 transmits the displacement to the small diameter piston 35.

The small diameter piston 35 pressurizes a ball valve 40 so that the high-pressure fuel in a high-pressure chamber 41 leaks to a fuel leakage chamber 37. A diameter tapered portion 351 having a cylindrical shape is formed at the top of the small diameter piston 35. The diameter tapered portion 351 press-contacts to an outer surface (which is a spherical surface) of the ball valve 40. Here, the high-pressure fuel 401 approximately having fuel injection pressure is introduced into the high-pressure chamber 41 from the common rail 400 through a high-pressure passage 42. Thus, the high-pressure fuel 401 pushes and raises the ball valve 40. By this press-up with the high-pressure fuel 401, the ball valve 40 is attached to a sheet surface 43 of the injector body 31 so that a clearance between the high-pressure chamber 41 and the fuel leakage chamber 37 is shut off (as shown in Fig. 7).

Further, when the ball valve 40 is pressed and displaced downward by the small diameter piston 35, the ball valve 40 is pushed down so that the ball valve 40 separates from the sheet surface 43. Thus, the high-pressure fuel 401 in the high-pressure chamber 41 leaks to the fuel leakage chamber 37. The fuel 402 leaked to the fuel leakage chamber 37 is discharged through a drain passage 38. Here, a reference number 39 represents a spring for press-contacting the small diameter piston 35 to the outer surface of the ball valve 40.

A pressure control chamber 45 connects to the high-pressure chamber 41 through a fuel passage 44. The high-pressure fuel is introduced into the pressure control chamber 45 from the common rail 400 through the high-pressure passage 42. A nozzle needle 47 is pushed by the high-pressure fuel and a spring 46 in the pressure control chamber 45 downwardly in Fig. 7. Thus, an injection port 48 disposed at the top of the injector 3 is closed.

In the injector 3 having the above construction, when the laminated piezoelectric device 1 is in a shrinkage state, the ball valve 40 keeps to be attached to the sheet surface 43. In this shrinkage state, the nozzle needle 47 keeps to be attached at a valve close position by the high-pressure fuel in the pressure control chamber 45. Therefore, the fuel does not inject from the injection port 48.

When the laminated piezoelectric device 1 extends, the small diameter piston 35 moves downward in Fig. 7 so that the small diameter piston 35 presses the ball valve 40. Thus, the ball valve 40 separates from the sheet surface 43, and then, the high-pressure fuel in the high-pressure chamber 41 leaks to the fuel leakage chamber 37. At this time, the pressure of the pressure control chamber 45 decreases, and the nozzle needle 47 moves toward an open valve direction (which is an upward direction in Fig. 7). Thus, the fuel is injected from the injection port 48.

In the laminated piezoelectric device 1 for using the injector 3 having the above construction, it is preferred that the constant K of the piezoelectric material is in a range between 1 and 1.3.

Since the volume elastic modulus of the fuel becomes larger as the temperature increases, the displacement of the large diameter piston 33 (i.e., the laminated piezoelectric device 1) is required to increase so that the inner pressure of the displacement-enhancing chamber 36 is increased.

## Claims

1. A method for driving a laminated piezoelectric device (1, 2A-2D), which comprises a piezoelectric stack (10) and a pair of side electrodes (151), wherein the piezoelectric stack (10) includes a plurality of piezoelectric layers (11) and a plurality of inner electrode layers (121, 122) which are laminated alternately, wherein each side electrode (151) is disposed on a side (101, 102) of the piezoelectric stack (10) for energizing every two inner electrode layers (121, 122), wherein each piezoelectric layer (11) is made of piezoelectric material having a rate of temperature dependence of piezoelectric modulus defined as RA, a rate of temperature dependence of capacitance defined as RC, and a constant value defined as K, and wherein the piezoelectric material has a relationship expressed as RA = K(RC)^{½}, the method comprising the step of:
energizing the inner electrode layers (121, 122) to keep energy of the laminated piezoelectric device (1, 2A-2D) constant,
wherein the constant value of K is in a range between 0.7 and 1.3, and
wherein the laminated piezoelectric device (1, 2A-2D) is used as a driving power source of an injector (3) for injecting fuel in an internal combustion engine
wherein RA = {D33(T1)-D33(T0)} / D33(T0) with D33 being the corresponding piezoelectric modulus, and T1 > T0,
wherein RC = {C(T1)-C(T0)} / C(TO) with C being the capacitance of a piezoelectric layer,
wherein a temperature range of the relationship of RA = K(RC)^{½} is between -50°C and 250°C, and
the energy per one piezoelectric layer is defined as (CAPACITANCE)X(VOLTAGE APPLIED TO BOTH SIDES OF PIEZOELECTRIC LAYERS)² ÷ 2.

2. The method according to claim 1,
wherein the piezoelectric material is made of an oxide having an ABO₃ perovskite-type structure.

3. The method according to claim 2,
wherein the piezoelectric material is made of lead zirconate titanate or barium titanate.

4. The method according to any one of claims 1 to 3,
wherein the step of energizing the inner electrode layers (121, 122) to keep energy constant is performed by controlling a charging time for charging the laminated piezoelectric device (1, 2A-2D) to be constant.

5. The method according to claim 4,
wherein the charging time is controlled in such a manner that variation rate of the energy for supplying the laminated piezoelectric device (1, 2A-2D) is in a range between -15% and +15% when temperature of the device (1, 2A-2D) is in a range between -50°C and 300°C.

6. The method according to any one of claims 1 to 5,
wherein the laminated piezoelectric device (1, 2A-2D) has a whole surface electrode construction, in which a side of the inner electrode layer (121, 122) exposes outside at an entire circumference of the side (101, 102) of the piezoelectric stack (10).

7. The method according to any one of claims 1 to 5,
wherein the laminated piezoelectric device (1, 2A-2D) has a partial surface electrode construction, in which a side of the inner electrode layer (121, 122) exposes outside partially from the side (101, 102) of the piezoelectric stack (10).

## Patentansprüche

1. Verfahren zur Ansteuerung einer geschichteten piezoelektrischen Vorrichtung (1, 2A-2D), die einen piezoelektrischen Stapel (10) und ein Paar von Seitenelektroden (151) umfasst, wobei der piezoelektrische Stapel (10) eine Vielzahl von piezoelektrischen Schichten (11) und eine Vielzahl von inneren Elektrodenschichten (121, 122) umfasst, die abwechselnd geschichtet sind, wobei jede Seitenelektrode (151) bei einer Seite (101, 102) des piezoelektrischen Stapels (10) angeordnet ist, um jede zwei inneren Elektroden (121, 122) mit Energie zu versorgen, wobei jede piezoelektrische Schicht (11) aus einem piezoelektrischen Material hergestellt ist, das eine Rate einer Temperaturabhängigkeit eines piezoelektrischen Moduls, die als RA definiert ist, eine Rate einer Temperaturabhängigkeit einer Kapazität, die als RC definiert ist, und einen konstanten Wert, der als K definiert ist, aufweist, und wobei das piezoelektrische Material eine Beziehung aufweist, die als RA = K(RC)^{½} ausgedrückt ist, wobei das Verfahren einen Schritt umfasst
zum Versorgen mit Energie der inneren Elektrodenschichten (121, 122), um eine Energie der geschichteten piezoelektrischen Vorrichtung (1, 2A-2D) konstant zu halten,
wobei der konstante Wert von K in einem Bereich zwischen 0,7 und 1,3 liegt und
wobei die geschichtete piezoelektrische Vorrichtung (1, 2A-2D) als eine Ansteuerungsenergiequelle für eine Einspritzvorrichtung (3) zum Einspritzen von Kraftstoff in eine Verbrennungskraftmaschine verwendet wird,
wobei RA = {D33(T1) - D33(T0)} / D33(T0) gilt, wobei D33 der entsprechende piezoelektrische Modul ist und T1 > T0 ist,
wobei RC = {C(T1) - C(T0)} / C(T0) gilt, wobei C die Kapazität einer piezoelektrischen Schicht ist,
wobei ein Temperaturbereich der Beziehung gemäß RA = K(RC)^{½} zwischen -50°C und 250°C liegt und
die Energie pro einer piezoelektrischen Schicht als (KAPAZITÄT)X(SPANNUNG, DIE AN BEIDE SEITEN DER PIEZOELEKTRISCHEN SCHICHTEN ANGELEGT WIRD)² ÷ 2 definiert ist.

2. Verfahren nach Anspruch 1,
wobei das piezoelektrische Material aus einem Oxid hergestellt wird, das eine ABO₃-Perovskit-Typ-Struktur aufweist.

3. Verfahren nach Anspruch 2,
wobei das piezoelektrische Material aus Blei-Zirkonat-Titanat oder Barium-Titanat hergestellt ist.

4. Verfahren nach einem der Ansprüche 1 bis 3,
wobei der Schritt zum Versorgen mit Energie der inneren Elektrodenschichten (121, 122), um die Energie konstant zu halten, durch eine Steuerung einer Ladungszeit zum Laden der geschichteten piezoelektrischen Vorrichtung (1, 2A-2D), um konstant zu sein, ausgeführt wird.

5. Verfahren nach Anspruch 4,
wobei die Ladungszeit auf eine derartige Art und Weise gesteuert wird, dass eine Variationsrate der Energie zum Versorgen der geschichteten piezoelektrischen Vorrichtung (1, 2A-2D) in einem Bereich zwischen -15% und +15% liegt, wenn die Temperatur der Vorrichtung (1, 2A-2D) in einem Bereich zwischen -50°C und 300°C liegt.

6. Verfahren nach einem der Ansprüche 1 bis 5,
wobei die geschichtete piezoelektrische Vorrichtung (1, 2A-2D) einen Gesamtoberflächenelektrodenaufbau aufweist, bei dem eine Seite der inneren Elektrodenschicht (121, 122) bei einem vollständigen Umfang der Seite (101, 102) des piezoelektrischen Stapels (10) nach außen freigelegt ist.

7. Verfahren nach einem der Ansprüche 1 bis 5,
wobei die geschichtete piezoelektrische Vorrichtung (1, 2A-2D) einen Teiloberflächenelektrodenaufbau aufweist, bei dem eine Seite der inneren Elektrodenschicht (121, 122) teilweise von der Seite (101, 102) des piezoelektrischen Stapels (10) nach außen freigelegt ist.

## Revendications

1. Procédé d'excitation d'un dispositif piézoélectrique en couches (1, 2A-2D), qui comprend un empilement piézoélectrique (10) et une paire d'électrodes latérales (151), dans lequel l'empilement piézoélectrique (10) comprend une pluralité de couches piézoélectriques (11) et une pluralité de couches d'électrodes intérieures (121, 122), qui sont disposées en couches alternées, dans lequel chaque électrode latérale (151) est disposée sur un côté (101, 102) de l'empilement piézoélectrique (10) pour alimenter une couche d'électrode intérieure sur deux (121, 122), dans lequel chaque couche piézoélectrique (11) est constituée de matériau piézoélectrique ayant un taux de dépendance d'un module piézoélectrique en fonction de la température défini par RA, un taux de dépendance en fonction d'une capacitance de la température défini par RC, et une valeur constante définie par K, et dans lequel le matériau piézoélectrique a une relation exprimée par RA = K(RC)^{½}, le procédé comprenant l'étape consistant à :
alimenter les couches d'électrodes intérieures (121, 122) pour maintenir constante une énergie du dispositif piézoélectrique en couches (1, 2A-2D),
dans lequel la valeur constante de K est dans une plage entre 0,7 et 1,3, et
dans lequel le dispositif piézoélectrique en couches (1, 2A-2D) est utilisé comme une source d'énergie d'excitation d'un injecteur (3) pour injecter un carburant dans un moteur à combustion interne,
dans lequel RA = {D33(T1)- D33(T0)} / D33(T0), D33 étant le module piézoélectrique correspondant, et T1 > T0,
dans lequel RC = {C(T1)- C(T0)} / C(T0), C étant la capacitance d'une couche piézoélectrique,
dans lequel une plage de température de la relation de RA = K(RC)^{½} est entre -50°C et 250° C, et
l'énergie par couche piézoélectrique est définie par (CAPACITANCE) X (TENSION APPLIQUEE AUX DEUX COTES DES COUCHES PIEZOELECTRIQUES)² /2.

2. Procédé selon la revendication 1, dans lequel le matériau piézoélectrique est constitué d'un oxyde ayant une structure de type pérovskite ABO₃.

3. Procédé selon la revendication 2, dans lequel le matériau piézoélectrique est constitué de titanate de zirconium et de plomb ou de titanate de baryum.

4. Procédé selon l'une quelconque des revendications 1 à 3, dans lequel l'étape d'alimentation des couches d'électrodes intérieures (121, 122) pour maintenir l'énergie constante est réalisée en contrôlant une durée de chargement pour charger le dispositif piézoélectrique en couches (1,2 A-2D), pour être constante.

5. Procédé selon la revendication 4, dans lequel la durée de chargement est contrôlée de telle sorte qu'un taux de variation de l'énergie pour alimenter le dispositif piézoélectrique en couches (1, 2A-2D) soit dans une plage entre - 15 % et + 15 % quand la température du dispositif (1,2 A-2D) est dans une plage entre - 50° C et 300° C.

6. Procédé selon l'une quelconque des revendications 1 à 5, dans lequel le dispositif piézoélectrique en couches (1,2 A-2D) a une construction d'électrode à surface entière, selon laquelle un côté de la couche d'électrode intérieure (121, 122) est exposé à l'extérieur sur une circonférence complète du côté (101, 102) de l'empilement piézoélectrique (10).

7. Procédé selon l'une quelconque des revendications 1 à 5, dans lequel le dispositif piézoélectrique en couches (1,2 A-2D) a une construction d'électrode à surface partielle, selon laquelle un côté de la couche d'électrode intérieure (121, 122) est partiellement exposé à l'extérieur à partir du côté (101, 102) de l'empilement piézoélectrique (10).
